Europäisches Patentamt

European Patent Office

Office européen des brevets

(11) Veröffentlichungsnummer: **0 344 670 B1**

## EUROPÄISCHE PATENTSCHRIFT

(45) Veröffentlichungstag der Patentschrift: **01.12.93**

(51) Int. Cl.⁵: $H01L\ 37/02$

(21) Anmeldenummer: **89109618.2**

(22) Anmeldetag: **29.05.89**

(54) **Pyroelektrischer Sensor.**

(30) Priorität: **01.06.88 CH 2067/88**

(43) Veröffentlichungstag der Anmeldung:
**06.12.89 Patentblatt 89/49**

(45) Bekanntmachung des Hinweises auf die
Patenterteilung:
**01.12.93 Patentblatt 93/48**

(84) Benannte Vertragsstaaten:
**AT BE CH DE ES FR GB IT LI NL SE**

(56) Entgegenhaltungen:
**US-A- 4 024 560**

**JOURNAL OF APPLIED PHYSICS, Band 61, Nr. 12, 15. Juni 1987, Seiten 5386-5391, American Institute of Physics, New York, US; A. HUANOSTA et al.: "The electrical properties of ferroelectric LiTaO3 and its solid solutions"**

**MATERIAL RESEARCH BULLETIN, Band 16, 1981, Seiten 1099-1106, Pergamon Press Ltd, Oxford, GB; B ELOUADI et al.: "Some new non-stoichiometric perroelectric phases appearing close to LiTaO3 in the ternary system Li2O-Ta2O5-(TiO2)2"**

**JOURNAL OF APPLIED CRYSTALLOGRAPHY, Band 3, 1970, Seiten 395-399, US; R.L. BARNS et al.: "Lithium tantalate single crystal stoichiometry"**

(73) Patentinhaber: **CERBERUS AG**
**Alte Landstrasse 411**
**CH-8708 Männedorf(CH)**

(72) Erfinder: **Forster, Martin**
**Sonnenbergstrasse 16**
**CH-8645 Jona(CH)**
Erfinder: **Illert, Claudia**
**Harmoniestrasse 9**
**CH-8712 Stäfa(CH)**

(74) Vertreter: **Tiemann, Ulrich, Dr.-Ing. et al**
**c/o Cerberus AG**
**Patentabteilung**
**Alte Landstrasse 411**
**CH-8708 Männedorf (CH)**

EP 0 344 670 B1

**Beschreibung**

Die Erfindung betrifft einen pyroelektrischen Sensor gemäß dem Oberbegriff des Patentanspruchs 1 und ein Verfahren zur Herstellung eines solchen Sensors.

Pyroelektrische Strahlungsempfänger (Strahlungsdetektoren, Pyrosensoren) bestanden ursprünglich zumeist aus einem dünnen pyroelektrischen Einkristall mit je einer Elektrode auf den Flächen senkrecht zur polaren Achse (vgl. z.B. J.Appl.Phys.Vol. 44, No. 2, S. 929-931 [Februar 1973]). Ein Problem bei der Herstellung solcher pyroelektrischen Strahlungsempfänger besteht allgemein darin, daß der Einkristall genau geschnitten werden muß, so daß die Ebenen der Elektrodenflächen senkrecht zu der ferroelektrischen Achse des Kristalls verlaufen.

Ein bervorzugtes Material für pyroelektrische Sensoren war Triglycinsulfat (TGS). Ein Nachteil der Verwendung dieses Materials besteht außer in dem vorgenannten Nachteil darin, daß es in Form von Einkristallen sehr brüchig ist und bei der Herstellung und Verwendung außerordentlich vorsichtig gehandhabt werden muß.

Es wurde daher vorgeschlagen (US-PS-3'511'991 [ = DE-OS-19'05'197]; GB-PS-1'377'625), pyroelektrische Detektorelemente dadurch herzustellen, daß man pyroelektrische Mikrokristalle, z.B. aus TGS oder Lithiumsulfatmonohydrat, mit einem Bindemittel auf ein Substrat aufbringt und die Ausrichtung der ferroelektrischen Achsen der Mikrokristalle durch einmaliges Anlegen einer polarisierenden Gleichspannung vornimmt.

Der in der US-PS-3'511'991 beschriebene pyroelektrische Detektor weist folgende Nachteile auf:
- Triglycinsalze haben eine Curie-Temperatur von weniger als 50°C; sie sind daher für Temperaturen über 50°C ungeeignet, da dann Depolarisation eintritt und der Sensor keine Signale mehr abgibt.
- Für eine rationelle Produktion muß es möglich sein, die Pyrosensoren auf eine Temperatur von ca. 150 - 200°C zu erhitzen, beispielsweise, zum Aushärten von Klebstoffen, zum Löten, zum Trocknen etc.; was natürlich mit den Triglycinsalzen nicht möglich ist.
- Der Gehalt an thermoplastischem Zement beträgt maximal 25 Gew.-% vom Triglycinsalz. Ein gößerer Gehalt an Bindemittel ist aber erwünscht, da dadurch die Dielektrizitätskonstante des pyroelektrischen Materials gesenkt werden kann, ohne daß sich der pyroelektrische Koeffizient stark verändert.
- Der thermoplastische Zement wird durch Erhitzen weich. Seine Verwendung ist daher völlig unmöglich, da das pyroelektrische Material bei erhöhter Temperatur gepolt werden muß.
- Das in dem genannten US-Patent erwähnte Lithiumsulfatmonohydrat ist stark hygroskopisch und liefert Pyrosensoren, die einen viel zu kleinen Gleichstrom-Widerstand haben. Durch Aufnahme von Wasser erfolgt ein Signalabfall.

In der GB-PS-1'377'625 ist ein Pyrosensor beschrieben, welcher aus einer in einem elektrisch isolierenden Bindemittel verteilten pyroelektrischen Keramik besteht. Der Gütefaktor dieses Pyrosensors ist jedoch unzureichend. (Der pyroelektrische Gütefaktor G ist definiert als

$$G = \frac{p}{DK \cdot D \cdot c} \quad [\, C \cdot cm/J],$$

worin p der pyroelektrische Koëffizient in $[\mu C/m^2 \cdot K]$, DK die Dielektrizitätskonstante, D die Dichte in $[g/cm^3]$ und c die Wärmekapazität in $[J/g \cdot K]$ bedeuten.)

Die Aufgabe der vorliegenden Erfindung besteht darin, einen pyroelektrischen Sensor zu schaffen, welcher die Nachteile der bekannten pyroelektrischen Sensoren vermeidet. Die Aufgabe der Erfindung besteht insbesondere darin einen pyroelektrischen Sensor zu schaffen, welcher eine erhöhte Curie-Temperatur (z.B. von ~ 610°C) aufweist, welcher während der Herstellung und des Betriebs des Detektors keine Depolarisation erleidet, bei welchem der pyroelektrische Koëffizient p und die Dielektrizitätskonstante DK im Bereich von -30°C bis +80°C praktisch temperaturunabhängig sind, welcher einen gegenüber den bekannten Pyrosensoren wesentlich verbesserten Gütefaktor aufweist, welcher einen hohen Gleichstrom-Widerstand aufweist und ein nicht hygroskopisches Material verwendet, so daß eine Alterung durch Wasseraufnahme verhindert wird.

Diese Aufgabe wird bei einem pyroelektrischen Sensor der eingangs gennanten Art durch die Merkmale des Patentanspruchs 1 und bei einem Verfahren durch die kennzeichnenden Merkmale des Patentanspruchs 7 gelöst.

Bevorzugte Ausführungsformen der Erfindung und Ausgestaltungen sind in den abhängigen Patentansprüchen definiert.

Als Bindemittel für die erfindungsgemäßen pyroelektrischen Sensoren werden Gläser verwendet, diese sind wasserabweisend und nicht hygroskopisch. Die Gläser haben eine Schmelztemperatur, welche über der Polungstemperatur des pyroelektrischen Materials liegt.

Im folgenden wird eine Reihe von Beispielen für die Herstellung der pyroelektrischen Sensoren beschrieben.

# Beispiel 1

==========

Ein Glaspulver, welches durch Vermischen von 2,57 g Borsäure, 0,33 g Aluminiumoxid, 1,35 g Siliciumdioxid, 5,86 g Bleioxid und 1,93 g Cadmiumacetat, Schmelzen bei 800°C und anschließendem Pulverisieren erhalten wurde, wurde mit soviel Terpineol vermischt, daß eine dünnflüssige Paste des Binders entstand. Einkristalle von Lithiumtantalat mit einem Anteil von 36,7 Mol-% Tantalpentoxid, 63 Mol-% Lithiumoxid und 0,3 Mol-% Vanadiumpentoxid wurden pulverisiert und gesiebt. Die Fraktion mit einer Korngröße von 5 bis 10 $\mu$m wurde mit der Binderpaste vermischt, so daß das Gewichtsverhältnis von Lithiumtantalat zu Binder 1,04 zu 1 betrug. Es wurde eine dickflüssige Paste erhalten, die mittels einer Schablone aus 50 $\mu$m dickem Stahlblech mit einer Oeffnung von 5x5 mm auf ein mit einer Goldelektrode versehenes Substrat aus Aluminiumoxid gestrichen wurde und dann bei 500°C eingebrannt wurde.

Über die erste Schicht wurde analog mit einer Blechschablone von 100 $\mu$m Dicke eine zweite Schicht aufgebracht und wieder bei 500°C eingebrannt. Die ganze pyroelektrische Schicht hatte nun eine Dicke von 107 $\mu$m. Auf diese zweite pyroelektrische Schicht wurde mittels Siebdruck eine Goldelektrode aufgebracht und ebenfalls bei 500°C eingebrannt. Als Siebdruckpaste wurde die handelsübliche Cermalloy C4350 verwendet. Nun wurde 5 Minuten lang bei 450°C zwischen oberer und unterer Elektrode eine elektrische Feldstärke von 4 MV/m angelegt und die pyroelektrische Schicht damit gepolt.

Die Schicht zeigte einen pyroelektrischen Gütefaktor

G = 0,420 • 10 exp-10 C•cm/J.

# Beispiel 2

==========

Es wurde dieselbe Binderpaste verwendet, und es wurde dasselbe Verhältnis von Lithiumtantalat zu Binder angewendet wie in Beispiel 1. Das Lithiumtantalat-Pulver wies eine Korngröße von <5 $\mu$m auf. Die pyroelektrische Schicht wurde wie in Beispiel 1 aufgetragen und gepolt.

Die Schicht zeigte einen pyroelektrischen Gütefaktor

G = 0,194 • 10 exp-10 C•cm/J.

# Beispiel 3

==========

Es wurde dieselbe Binderpaste verwendet, und es wurde dasselbe Verhältnis von Lithiumtantalat zu Binder angewendet wie in Beispiel 1. Das Lithiumtantalat-Pulver wies eine Korngröße von 10 bis 20 $\mu$m auf. Die pyroelektrische Schicht wurde wie in Beispiel 1 aufgetragen und gepolt.

Die Schicht zeigte einen pyroelektrischen Gütefaktor

G = 0,733 • 10 exp-10 C•cm/J.

## Beispiel 4

Es wurde dieselbe Binderpaste verwendet, und es wurde dasselbe Verhältnis von Lithiumtantalat zu Binder angewendet wie in Beispiel 1. Das Lithiumtantalat-Pulver wies eine Korngröße von 20 bis 75 $\mu$m auf. Die pyroelektrische Schicht wurde wie in Beispiel 1 aufgetragen und gepolt.

Die Schicht zeigte einen pyroelektrischen Gütefaktor

G = 0,773 · 10 exp-10 C·cm/J.

## Beispiel 5

Es wurde dieselbe Binderpaste verwendet wie in Beispiel 1. Das Verhältnis von Lithiumtantalat zu Binder betrug in diesem Fall 1,2 zu 1. Das Lithiumtantalat-Pulver wies eine Korngröße von 10 bis 20 $\mu$m auf. Die pyroelektrische Schicht wurde wie in Beispiel 1 aufgetragen und durch Anlegen einer elektrischen Feldstärke von 4,4 MV/m gepolt.

Die Schicht zeigte einen pyroelektrischen Gütefaktor

G = 0,776 · 10 exp-10 C·cm/J.

## Beispiel 6

Es wurde dieselbe Binderpaste verwendet wie in Beispiel 1. Das Verhältnis von Lithiumtantalat zu Binder betrug in diesem Fall 0,8 zu 1. Das Lithiumtantalat-Pulver wies eine Korngröße von 10 bis 20 $\mu$m auf. Die pyroelektrische Schicht wurde wie in Beispiel 1 aufgetragen und durch Anlegen einer elektrischen Feldstärke von 4,5 MV/m gepolt.

Die Schicht zeigte einen pyroelektrischen Gütefaktor

G = 0,714 · 10 exp-10 C·cm/J.

## Beispiel 7

Es wurde dieselbe Binderpaste verwendet wie in Beispiel 1. Das Verhältnis von Lithiumtantalat zu Binder betrug in diesem Fall 0,6 zu 1. Das Lithiumtantalat-Pulver wies eine Korngröße von 10 bis 20 $\mu$m auf. Die pyroelektrische Schicht wurde wie in Beispiel 1 aufgetragen und durch Anlegen einer elektrischen Feldstärke von 4,1 MV/m gepolt.

Die Schicht zeigte einen pyroelektrischen Gütefaktor

G = 0,525 · 10 exp-10 C·cm/J.

## Beispiel 8

Es wurde dieselbe Binderpaste verwendet wie in Beispiel 1. Das Verhältnis von Lithiumtantalat zu Binder betrug in diesem Fall 0,4 zu 1. Das Lithiumtantalat-Pulver wies eine Korngröße von 10 bis 20 $\mu$m

auf. Die pyroelektrische Schicht wurde wie in Beispiel 1 aufgetragen und durch Anlegen einer elektrischen Feldstärke von 3,1 MV/m gepolt.

Die Schicht zeigte einen pyroelektrischen Gütefaktor

G = 0,177 • 10 exp-10 C•cm/J.


## Beispiel 9

Es wurde dieselbe Binderpaste verwendet wie in Beispiel 1. Das Verhältnis von Lithiumtantalat zu Binder betrug in diesem Fall 1,6 zu 1. Das Lithiumtantalat-Pulver wies eine Korngröße von 10 bis 20 $\mu$m auf. Die pyroelektrische Schicht wurde wie in Beispiel 1 aufgetragen und durch Anlegen einer elektrischen Feldstärke von 1,2 MV/m gepolt.

Die Schicht zeigte einen pyroelektrischen Gütefaktor

G = 0,515 • 10 exp-10 C•cm/J.


## Beispiel 10

Es wurde dieselbe Binderpaste verwendet wie in Beispiel 1. Das Verhältnis von Lithiumtantalat zu Binder betrug in diesem Fall 2,4 zu 1. Das Lithiumtantalat-Pulver wies eine Korngröße von 10 bis 20 $\mu$m auf. Die pyroelektrische Schicht wurde wie in Beispiel 1 aufgetragen und durch Anlegen einer elektrischen Feldstärke von 2,0 MV/m gepolt.

Die Schicht zeigte einen pyroelektrischen Gütefaktor

G = 0,364 • 10 exp-10 C•cm/J.


## Beispiel 11

Ein Glaspulver, welches durch Vermischen von 1,26 g Borsäure, 0,49 g Aluminiumoxid, 1,22 g Siliciumdioxid, 7,36 g Bleioxid und 0,52 g Cadmiumacetat, Schmelzen bei 850°C und anschließendem Pulverisieren erhalten wurde, wurde mit soviel Terpineol vermischt, daß eine dünnflüssige Paste des Binders entstand. Einkristalle von Lithiumtantalat mit einem Anteil von 51,3 Mol-% Tantalpentoxid, und 48,7 Mol-% Lithiumoxid wurden pulverisiert und gesiebt. Die Fraktion mit einer Korngröße von 10 bis 20 $\mu$m wurde mit der Binderpaste vermischt, so daß das Gewichtsverhältnis von Lithiumtantalat zu Binder 1,6 zu 1 betrug. Es wurde eine dickflüssige Paste erhalten, die mittels eines Siebs mit 200 mesh und einer Emulsion von 50 $\mu$m Dicke mit einer Öffnung von 5x5 mm auf ein mit einer Goldelektrode versehenes Substrat aus Aluminiumoxid gestrichen und dann bei 500°C eingebrannt wurde.

Über die erste Schicht wurde analog mit demselben Sieb eine zweite Schicht aufgebracht und wieder bei 500°C eingebrannt. Die ganze pyroelektrische Schicht hatte nun eine Dicke von 99 $\mu$m. Auf diese zweite pyroelektrische Schicht wurde mittels Siebdruck eine Goldelektrode aufgebracht und ebenfalls bei 500°C eingebrannt. Als Siebdruckpaste wurde die handelsübliche Cermalloy C4350 verwendet. Nun wurde 5 Minuten lang bei 450°C zwischen oberer und unterer Elektrode eine elektrische Feldstärke von 4 MV/m angelegt und die pyroelektrische Schicht damit gepolt.

Die Schicht zeigte einen pyroelektrischen Gütefaktor

G = 0,651 • 10 exp-10 C•cm/J.

## Beispiel 12

■■■■■■■■■■

Es wurde dieselbe Binderpaste verwendet wie in Beispiel 11. Das Verhältnis von Lithiumtantalat zu Binder betrug in diesem Fall 0,4 zu 1. Das Lithiumtantalat-Pulver wies eine Korngröße von 10 bis 20 $\mu$m auf. Die pyroelektrische Schicht wurde wie in Beispiel 11 aufgetragen und durch Anlegen einer elektrischen Feldstärke von 4,0 MV/m gepolt.

Die Schicht zeigte einen pyroelektrischen Gütefaktor

G = 0,237 • 10 exp-10 C•cm/J.

## Beispiel 13

■■■■■■■■■■

Es wurde dieselbe Binderpaste verwendet wie in Beispiel 11. Das Verhältnis von Lithiumtantalat zu Binder betrug in diesem Fall 1,1 zu 1. Das Lithiumtantalat-Pulver wies eine Korngröße von 10 bis 20 $\mu$m auf. Die pyroelektrische Schicht wurde wie in Beispiel 11 aufgetragen und durch Anlegen einer elektrischen Feldstärke von 4,0 MV/m gepolt.

Die Schicht zeigte einen pyroelektrischen Gütefaktor

G = 0,555 • 10 exp-10 C•cm/J.

## Beispiel 14

■■■■■■■■■■

Es wurde dieselbe Binderpaste verwendet wie in Beispiel 11. Das Verhältnis von Lithiumtantalat zu Binder betrug in diesem Fall 0,8 zu 1. Das Lithiumtantalat-Pulver wies eine Korngröße von 10 bis 20 $\mu$m auf. Die pyroelektrische Schicht wurde wie in Beispiel 11 aufgetragen und durch Anlegen einer elektrischen Feldstärke von 4,0 MV/m gepolt.

Die Schicht zeigte einen pyroelektrischen Gütefaktor

G = 0,447 • 10 exp-10 C•cm/J.

## Beispiel 15

■■■■■■■■■■

Es wurde dieselbe Binderpaste verwendet wie in Beispiel 11. Das Verhältnis von Lithiumtantalat zu Binder betrug in diesem Fall 3,9 zu 1. Das Lithiumtantalat-Pulver wies eine Korngröße von 10 bis 20 $\mu$m auf. Die pyroelektrische Schicht wurde wie in Beispiel 11 aufgetragen und durch Anlegen einer elektrischen Feldstärke von 4,0 MV/m gepolt.

Die Schicht zeigte einen pyroelektrischen Gütefaktor

G = 0,306 • 10 exp-10 C•cm/J.

## Beispiel 16

■■■■■■■■■■

Ein Glaspulver, welches Vermischen von 2,74 g Borsäure, 0,27 g Aluminiumoxid, 1,09 g Siliciumdioxid, 4,7 g Bleioxid, 1,55 g Cadmiumacetat und 3,57 g Vanadiumpentoxdid, Schmelzen bei 1200°C und anschließendem Pulverisieren erhalten wurde, wurde mit soviel Terpineol vermischt, daß eine dünnflüssige Paste des Binders entstand. Einkristalle von Lithiumtantalat mit derselben chemischen Zusammensetzung wie in Beispiel 1 wurden pulverisiert und gesiebt. Die Fraktion mit einer Korngröße von <20 $\mu$m wurde mit der Binderpaste vermischt, so daß das Gewichtsverhältnis von Lithiumtantalat zu Binder 1,04 zu 1 betrug. Es wurde eine dickflüssige Paste erhalten, die mittels eines Siebs mit 200 mesh und einer Emulsion von 100 $\mu$m Dicke mit einer Öffnung von 5x5 mm auf ein mit einer Goldelektrode versehenes Substrat aus Aluminiumoxid gestrichen und dann bei 700°C eingebrannt wurde.

Die pyroelektrische Schicht wies eine Dicke von 102 $\mu$m auf. Mittels Siebdruck wurde eine Goldelektrode aufgebracht und ebenfalls bei 500°C eingebrannt. Als Siebdruckpaste wurde die handelsübliche Cermalloy C4350 verwendet. Nun wurde 5 Minuten lang bei 450°C zwischen oberer und unterer Elektrode eine elektrische Feldstärke von 4 MV/m angelegt und die pyroelektrische Schicht damit gepolt.

Die Schicht zeigte einen pyroelektrischen Gütefaktor

G = 0,551 · 10 exp-10 C·cm/J.

## Beste Ausführungsform für den pyroelektrischen Sensor:

**==============================**

Binderzusammensetzung:

Das Glaspulver soll von den sechs Elementen Bor, Aluminium, Silicium, Blei, Cadmium, Vanadium in Form ihrer Oxide jeweils Blei und mindestens drei weitere enthalten. Die Anteile dieser sechs Elemente im Glas in Gewichtsprozenten, bezogen auf 100% = Summe der Gewichte dieser 6 Elemente (nicht Oxide!), betragen:

|  |  | bevorzugt |
|---|---|---|
| Bor: | 0 - 25 % | 1 - 10 % |
| Aluminium: | 0 - 20 % | 1 - 10 % |
| Silicium: | 0 - 50 % | 2 - 20 % |
| Blei: | 40 - 99 % | 60 - 92 % |
| Cadmium: | 0 - 40 % | 1 - 20 % |
| Vanadium: | 0 - 50 % | 0 - 30 % |

Der Binder kann auch noch bis zu einem Gehalt von 5 Gew.-% Oxide von Chrom, Nickel und/oder Cobalt enthalten . Die Vorteile dieser Zusätze bestehen in der Färbung der Schicht, um sie später beim Zusammenbau evtl. besser erkennen zu können.

Lithiumtantalat-Zusammensetzung:

Die optimale stöchiometrische Zusammensetzung des Lithiumtantalats liegt im Bereich von 25 bis 75 Mol-% Tantalpentoxid. Der bevorzugte Bereich ist 35 bis 65 Mol-% Tantalpentoxid, speziell bevorzugt ist 45 bis 55 Mol-% Tantalpentoxid.

Zusätzlich kann das Lithiumtantalat noch bis zu 15 Mol-% Vanadiumpentoxid enthalten.

Mischungsverhältnisse Lithiumtantalat/Binder:

Der optimale Bereich in Gewichtsteilen Lithiumtantalat zu Binder ist 0,1 : 1 bis 5 : 1; bevorzugter Bereich ist 0,3 : 1 bis 3 : 1.

Je nach chemischer Zusammensetzung der Binder kann das spezifische Gewicht der Binder stark variieren. Optimale Bedingungen scheinen ein Volumenverhältnis von ca. 1 : 1 zwischen Lithiumtantalat und Binder zu sein.

Schichtdicken:

Die optimale Schichtdicke der pyroelektrischen Schicht liegt im Bereich von 1 bis 300 $\mu$m, vorzugsweise 20 bis 150 $\mu$m, Dicke.

Korngröße:

Die optimale Korngröße liegt im Bereich von 0,1 bis 75 $\mu$m, vorzugsweise 1,0 bis 20 $\mu$m.

Größe der pyroelektrischen Schicht:

Die Breite und Länge der pyroelektrischen Schicht ist völlig frei wählbar und ist nur durch die Größe der verwendeten Siebdruckmaschine begrenzt. Als praktisch kleinste Abmessungen haben sich ergeben: ca. 0,3 x 0,3 mm$^2$.

Abwandlungen der vorbeschriebenen Ausführungsformen für pyroelektrische Sensoren sind im Rahmen der Erfindung gemäß den Ansprüchen möglich und dem Fachmann geläufig.

**Patentansprüche**

1. Pyroelektrischer Sensor bestehend aus einem Substrat, darauf aufgebrachtem, in einem Bindemittel verteilten, pyroelektrischen Material und mindestens zwei elektrisch leitend damit verbundenen Elektroden, dadurch gekennzeichnet, daß das pyroelektrische Material aus einkristallinen Teilchen bestehendes Lithiumtantalat enthält, das aus dem stöchiometrischen Bereich von 25 bis 75 Mol.-% Tantalpentoxid stammt und das in einem Bindemittel aus Glas verteilt ist.

2. Pyroelektrischer Sensor gemäß Patentanspruch 1, dadurch gekennzeichnet, daß das Lithiumtantalat aus dem stöchiometrischen Bereich von 35 bis 65 Mol.-% Tantalpentoxid stammt und eine Korngröße von 0,1 bis 75 $\mu$m, vorzugsweise 1,0 bis 20 $\mu$m, aufweist.

3. Pyroelektrischer Sensor gemäß Patentanspruch 1, dadurch gekennzeichnet, daß das als Bindemittel dienende Glas Bleioxid und mindestens drei der Oxide von Bor, Aluminium, Silicium, Cadmium und Vanadium enthält.

4. Pyroelektrischer Sensor gemäß Patentanspruch 3, dadurch gekennzeichnet, daß das Bindemittel aus einem Glas besteht, welches die Oxide von Bor (0 bis 25 Gew.-%, vorzugsweise 1 bis 10 Gew.-% [bezogen jeweils auf das Element]), Aluminium (0 bis 20 Gew.-%, vorzugsweise 1 bis 10 Gew.-%), Silicium (0 bis 50 Gew.-%, vorzugsweise 2 bis 20 Gew.-%), Blei (40 bis 99 Gew.-%, vorzugsweise 60 bis 92 Gew.-%), Cadmium (0 bis 40 Gew.-%, vorzugsweise 1 bis 20 Gew.-%) und Vanadium (0 bis 50 Gew.-%, vorzugsweise 0 bis 30 Gew.-%) enthält.

5. Pyroelektrischer Sensor gemäß Patentanspruch 4, dadurch gekennzeichnet, daß das Bindemittel aus einem Glas besteht, welches zusätzlich einen Gehalt von maximal 5 Gew.-% an den Oxiden von Chrom, Nickel und/oder Cobalt aufweist.

6. Pyroelektrischer Sensor gemäß einem der Patentansprüche 1 bis 5, dadurch gekennzeichnet, daß das Gewichtsverhältnis von Lithiumtantalat zu Bindemittel zwischen 0,1 : 1 und 5 : 1 beträgt.

7. Verfahren zur Herstellung des pyroelektrischen Sensors gemäß Patentanspruch 1, dadurch gekennzeichnet, daß ein durch Zusammenschmelzen von Bleioxid und mindestens drei der Oxide von Bor, Aluminium, Silicium, Cadmium und Vanadium erhaltenes Bindemittel pulverisiert und mit einem hochsiedenden organischen Lösungsmittel zu einer dünnflüssigen Paste verrieben wird, welche mit einer solchen Menge feinpulverisiertem, aus einkristallinen Teilchen bestehendem, eine Korngröße von 0,1 bis 75 $\mu$m aufweisendem Lithiumtantalat vermischt wird, daß Lithiumtantalat und Bindemittel im Gewichtsverhältnis von 0,1 : 1 bis 5 : 1 vorliegen, daß die so erhaltene dickflüssige Paste in dünner Schicht auf ein mit einer Edelmetallelektrode versehenes inertes Substrat aufgebracht und bei erhöhter Temperatur eingebrannt wird, daß mittels Siebdruck eine zweite aus inertem Metall bestehende Elektrode aufgebracht wird und daß die so erhaltene Schicht durch Anlegen einer Feldstärke von einigen MV/m an die Elektroden gepolt wird, wobei beim Auftragen der dickflüssigen Paste die Bedingungen so gewählt werden, daß sich nach dem Einbrennen eine Schichtdicke von 1 bis 300 $\mu$m ergibt.

**8.** Verfahren gemäß Patentanspruch 7, dadurch gekennzeichnet, daß die Bedingungen beim Auftragen der dickflüssigen Paste so gewählt werden, daß sich nach dem Einbrennen eine Schichtdicke von 2 bis 150 $\mu$m ergibt.

**9.** Verfahren gemäß Patentanspruch 7, dadurch gekennzeichnet, daß das Bindemittel außerdem Oxide von Chrom, Nickel und/oder Cobalt enthält.

**10.** Verfahren gemäß Patentanspruch 7, dadurch gekennzeichnet, daß das Lithiumtantalat durch Pulverisieren von Einkristallen von Lithiumtantalat mit einem Gehalt von 25 bis 75 Mol.-% Tantalpentoxid, vorzugsweise von 35 bis 65 Mol.-% Tantalpentoxid, insbesondere von 45 bis 55 Mol-% Tantalpentoxid, und Verwendung der Fraktion mit einer Korngröße von 0,1 bis 75 $\mu$m, vorzugsweise von 1,0 bis 20 $\mu$m, erhalten wurde.

## Claims

**1.** Pyroelectric sensor, comprising a substrate, pyroelectric material applied thereto dispersed in a binder, and at least two electrodes connected thereto in an electrically conductive manner, characterised in that the pyroelectric material contains lithium tantalate which consists of single-crystal particles, comes from the stoichiometric range of from 25 to 75 mol % of tantalum pentoxide and is dispersed in a binder made of glass.

**2.** Pyroelectric sensor according to Claim 1, characterised in that the lithium tantalate comes from the stoichiometric range of from 35 to 65 mol % of tantalum pentoxide and has a particle size of from 0.1 to 75 $\mu$m, preferably from 1.0 to 20 $\mu$m.

**3.** Pyroelectric sensor according to Claim 1, characterised in that the glass serving as a binder contains lead oxide and at least three of the oxides of boron, aluminium, silicon, cadmium and vanadium.

**4.** Pyroelectric sensor according to Claim 3, characterised in that the binder consists of a glass which contains the oxides of boron (from 0 to 25 % by weight, preferably from 1 to 10 % by weight [based on the element in each case]), aluminium (from 0 to 20 % by weight, preferably from 1 to 10 % by weight), silicon (from 0 to 50 % by weight, preferably from 2 to 20 % by weight), lead (from 40 to 99 % by weight, preferably from 60 to 92 % by weight), cadmium (from 0 to 40 % by weight, preferably from 1 to 20 % by weight) and vanadium (from 0 to 50 % by weight, preferably from 0 to 30 % by weight).

**5.** Pyroelectric sensor according to Claim 4, characterised in that the binder consists of a glass which additionally has a content of at most 5 % by weight of the oxides of chromium, nickel and/or cobalt.

**6.** Pyroelectric sensor according to any one of Claims 1 to 5, characterised in that the weight ratio of lithium tantalate to binder is from 0.1:1 to 5:1.

**7.** Process for preparing the pyroelectric sensor according to Claim 1, characterised in that a binder obtained by fusing lead oxide and at least three of the oxides of boron, aluminium, silicon, cadmium and vanadium is pulverised and ground with a high-boiling organic solvent to give a low-viscosity paste which is mixed with such an amount of finely powdered lithium tantalate which consists of single-crystal particles and has a particle size of from 0.1 to 75 $\mu$m that lithium tantalate and binder are present in a weight ratio of from 0.1:1 to 5:1, in that the viscous paste thus obtained is applied in a thin layer to an inert substrate provided with a noble-metal electrode and is fired at elevated temperature, in that, by means of screen-printing, a second electrode consisting of inert metal is applied and in that the layer thus obtained is poled by applying a field strength of several MV/m to the electrodes, the conditions, when applying the viscous paste, being chosen so as to produce a layer thickness, after firing, of from 1 to 300 $\mu$m.

**8.** Process according to Claim 7, characterised in that the conditions, when applying the viscous paste, are chosen so as to produce a layer thickness, after firing, of from 2 to 150 $\mu$m.

**9.** Process according to Claim 7, characterised in that the binder additionally contains oxides of chromium, nickel and/or cobalt.

**10.** Process according to Claim 7, characterised in that the lithium tantalate was obtained by pulverising single crystals of lithium tantalate having a content of from 25 to 75 mol % of tantalum pentoxide, preferably from 35 to 65 mol % of tantalum pentoxide, especially from 45 to 55 mol % of tantalum pentoxide, and employing the fraction having a particle size of from 0.1 to 75 $\mu$m, preferably from 1.0 to 20 $\mu$m.

**Revendications**

**1.** Capteur pyroélectrique constitué d'un substrat, sur lequel est déposé un matériau pyroélectrique réparti dans un liant, et au moins deux électrodes reliées de façon électroconductrice à ce matériau, caractérisé par le fait que le matériau pyroélectrique contient du tantalate de lithium qui est constitué de particules monocristallines, qui est obtenu à partir de la gamme stoechiométrique comprise entre 25 et 75 % en moles de pentoxyde de tantale, et qui est réparti dans un liant en verre.

**2.** Capteur pyroélectrique suivant la revendication 1, caractérisé en ce que le tantalate de lithium est obtenu à partir de la gamme stoechiométrique comprise entre 35 et 65 % en moles de pentoxyde de tantale et possède une granulométrie comprise entre 0,1 et 75 $\mu$m et de préférence entre 1,0 et 20 $\mu$m.

**3.** Capteur pyroélectrique suivant la revendication 1, caractérisé en ce que le verre utilisé comme liant contient de l'oxyde de plomb et au moins trois des oxydes de bore, d'aluminium, de silicium, de cadmium et de vanadium.

**4.** Capteur pyroélectrique suivant la revendication 3, caractérisé en ce que le liant est formé d'un verre, qui contient de l'oxyde de bore (0 à 25 % en poids, de préférence 1 à 10 % en poids) [rapportés respectivement à l'élément], de l'oxyde d'aluminium (0 à 20% en poids, de préférence 1 à 10% en poids), de l'oxyde de silicium (0 à 50% en poids, de préférence 2 à 20% en poids), de l'oxyde de plomb, (40 à 99% en poids, de préférence 60 à 92% en poids), de l'oxyde de cadmium, (0 à 40% en poids, de préférence 1 à 20% en poids), et de l'oxyde de vanadium (0 à 50% en poids, 0 à 30% en poids).

**5.** Capteur pyroélectrique suivant la revendication 4, caractérisé en ce que le liant est formé d'un verre qui contient en outre une teneur égale au maximum à 5% en poids en oxydes de chrome, de nickel et/ou de cobalt.

**6.** Capteur pyroélectrique suivant l'une des revendications 1 à 5, caractérisé en ce que le rapport pondéral du tantalate de lithium au liant est compris entre 0,1 : 1 et 5 : 1.

**7.** Procédé pour fabriquer le capteur pyroélectrique suivant la revendication 1, caractérisé en ce qu'on pulvérise un liant obtenu en faisant fondre conjointement de l'oxyde de plomb et au moins trois des oxydes de bore, d'aluminium, de cadmium et de vanadium, et qu'on le triture avec un solvant organique à point d'ébullition élevé pour former une pâte très fluide, qui est mélangée à une quantité de tantalate de lithium finement pulvérisé, constitué de molécules monocristallines et possédant une granulométrie comprise entre 0,1 et 75 $\mu$m, que le tantalate de lithium et le liant sont présents dans un rapport pondéral de 0,1 : 1 à 5 : 1, qu'on dépose la pâte visqueuse ainsi obtenue sous la forme d'une couche mince, sur un substrat inerte pourvu d'une électrode en métal précieux et qu'on la fait cuire à une température accrue, qu'on dépose par sérigraphie une seconde électrode en métal inerte et qu'on polarise la couche ainsi obtenue en appliquant une intensité de champ de quelques MV/m aux électrodes, le coefficient lors du dépôt de la pâte étant choisi de manière à obtenir après la cuisson une épaisseur de couche de 1 à 300 $\mu$m.

**8.** Procédé suivant la revendication 7, caractérisé en ce qu'on choisit les conditions de dépôt de la pâte visqueuse de telle sorte qu'après la cuisson, on obtient une épaisseur de couche de 2 à 150 $\mu$m.

**9.** Procédé suivant la revendication 7, caractérisé en ce que le liant contient en outre des oxydes de chrome, de nickel et/ou de cobalt.

**10.** Procédé suivant la revendication 7, caractérisé en ce qu'on a obtenu le tantalate de lithium par pulvérisation de monocristaux de tantalate de lithium possédant une teneur de 25 à 75% en moles de pentoxyde de tantale, de préférence de 35 à 65% en moles de pentoxyde de tantale, en particulier de 45 à 55% en moles de pentoxyde de tantale, et utilisation de la fraction possédant une granulométrie de 0,1 à 75 $\mu$m et de préférence de 1,0 à 20 $\mu$m.